# EUROPÄISCHE PATENTSCHRIFT

(11) **EP 2 330 865 B1**
(45) Veröffentlichungstag und Bekanntmachung des Hinweises auf die Patenterteilung: **21.10.2015**
(21) Anmeldenummer: 09015002.0
(22) Anmeldetag: 03.12.2009
(51) Int. Cl.: H05B 3/50, B60H 1/22, H05K 3/34

(54) **Elektrische Heizvorrichtung**
Electric heating device
Dispositif de chauffage électrique

(43) Veröffentlichungstag der Anmeldung: 08.06.2011
(73) Patentinhaber: Eberspächer catem GmbH & Co. KG, 76863 Herxheim (DE)
(72) Erfinder: Bohlender, Franz, 76870 Kandel (DE); Reiß, Holger, 76764 Rheinzabern (DE); Niederer, Michael, 76889 Kapellen Drusweiler (DE); Attmann, Sven, 76857 Silz (DE)
(74) Vertreter: Grünecker Patent- und Rechtsanwälte PartG mbB

(56) Entgegenhaltungen:
- EP-A2- 1 104 046
- EP-A2- 1 253 808
- US-A- 4 536 826
- US-A- 5 847 934
- US-A1- 2006 084 291

## Beschreibung

Die vorliegende Erfindung betrifft eine elektrische Heizvorrichtung, insbesondere eine Heizvorrichtung für ein Kraftfahrzeug, mit einem Heizblock umfassend wenigstens ein wärmeabgebendes Element, welches wärmeleitend mit einem wenigstens ein PTC-Element umfassenden wärmeerzeugenden Element verbunden ist. Die elektrische Heizvorrichtung hat des Weiteren ein Gehäuse zur Aufnahme des Heizblocks und eine in baulicher Einheit mit dem Heizblock vorgesehene Steuervorrichtung. Als Teil der Steuervorrichtung ist eine Leiterplatte vorgesehen, die mit Bauelementen bestückt und mit wenigstens einer Stromschiene kontaktiert ist.

Eine solche elektrische Heizvorrichtung ist beispielsweise aus der auf die vorliegende Anmelderin zurückgehenden EP 1 253 808 A2 bekannt. Die bauliche Einheit wird dabei regelmäßig durch ein aus Kunststoff gebildetes Gehäuse gewährleistet, welches sowohl den Heizblock als auch die Steuervorrichtung in sich aufnimmt. Das Gehäuse kann mehrteilig ausgebildet sein.

Bei gattungsgemäßen Heizvorrichtungen, die üblicherweise mit der Bordnetzspannung von 12 Volt betrieben werden, kommen wegen der damit einhergehenden relativ hohen Stromlast von bis zu 160 A Ampere bei den gewünschten Heizleistungen von bis zu 2000 Watt Stromschienen zum Einsatz, die zu der Leiterplatte eine außerhalb der Leiterplatte vorgesehene Leiterbahn für den hohen Laststrom bereitstellen. Nach dem Stand der Technik ist es bekannt, Blechstreifen zur Kontaktierung einer Leiterplatte so zu umbiegen, dass diese Blechstreifen an gegenüberliegenden Seiten der Leiterplatte anliegend und die Leiterplatte umgreifen. Entsprechende Lösungsvorschläge sind beispielsweise aus der US 2006/0084 A1, der US 5,827,934 sowie US 4,536,826 bekannt.

In der Praxis werden die Stromschienen als Teil des Aufbaus der Leiterplatte von dem Elektronikhersteller gefertigt und an der Leiterplatte vorgesehen. Die Befestigung der Stromschiene erfolgt dementsprechend mit Verbindungs- und Befestigungstechniken, die dem Elektronikhersteller geläufig sind. Regelmäßig ist aber ein relativ hoher Aufwand notwendig, die Stromschiene mit der Leiterplatte zu verbinden. Die Stromschiene muss nicht nur elektrisch leitend mit ausgewählten Bereichen der Leiterplatte verbunden werden. Vielmehr ist es auch erforderlich, an der Stromschiene vorgesehene Anschlusskontakte für den Leistungs- bzw. Laststrom mit der notwendigen Festigkeit auf der Leiterplatte unmittelbar oder mittelbar über die Stromschiene zu befestigen. Die hohe Vibrationsbelastung, die eine gattungsgemäße elektrische Heizvorrichtung bei einem Einsatz in einem Kraftfahrzeug auszuhalten hat, stellt hier besondere Anforderungen an die Verbindungstechnik. Bei unzureichender Verbindung kann es zu Übergangswiderständen zwischen der

Stromschiene und der Leiterplatte kommen, die mitunter zur Funkenbildung und lokalen Überhitzung bzw. thermischen Ereignissen bei der elektrischen Heizvorrichtung führen. Der vorliegenden Erfindung liegt die Aufgabe zugrunde, eine gattungsgemäße elektrische Heizvorrichtung anzugeben, die sich leichter und wirtschaftlicher, jedoch ohne Beeinträchtigung der zu stellenden Anforderungen an die elektrische Kontaktierung zwischen der Leiterplatte und der Stromschiene herstellen lässt. Die vorliegende Erfindung will ferner eine Leiterplatte angeben, die sich insbesondere in einer gattungsgemäßen elektrischen Heizvorrichtung einsetzen lässt und die mit der Stromschiene auf einfache und zuverlässige Weise kontaktiert ist.

Zur Lösung des obigen Problems im Hinblick auf die elektrische Heizvorrichtung wird mit der vorliegenden Erfindung eine Heizvorrichtung mit den Merkmalen von Anspruch 1 angegeben.

Diese unterscheidet sich von der gattungsgemäßen elektrischen Heizvorrichtung dadurch, dass die Stromschiene erste und zweite Auflagen ausbildet, wobei die ersten Auflagen mit einer ersten Oberfläche der Leiterplatte und die zweiten Auflagen mit einer zweiten Oberfläche der Leiterplatte zusammenwirken. Als Oberflächen der Leiterplatte werden dabei regelmäßig die sich gegenüberliegenden und mit elektronischen bzw. elektrischen Bauteilen bestückten Flächen der Leiterplatte angesehen, nicht die durch den umlaufenden Rand bereitgestellte Oberfläche. Die Stromschiene ist erfindungsgemäß auf beiden Seiten der Leiterplatte vorgesehen. Mit anderen Worten hat die Stromschiene Bereiche, die sich auf der ersten Oberfläche der Leiterplatte befinden, wohingegen andere Bereiche sich auf der zweiten Oberfläche der Leiterplatte befinden. Durch diese Anordnung von verschiedenen Bereichen der Stromschiene zugeordnet zu unterschiedlichen Bereichen der Leiterplatte kann eine genaue Positionierung und/oder Halterung der Stromschiene an der Leiterplatte erreicht werden. Dabei geht die Erfindung insbesondere davon aus, dass sich die Stromschiene über wenigstens zwei Stützstellen an der Leiterplatte abstützt. Diese Stützstellen werden durch Auflagen ausgebildet, die durch vorbestimmte Abschnitte der Stromschiene ausgeformt sind. Sofern dieser vorbestimmte Abschnitt großflächig an der Leiterplatte anliegt, bildet dieser großflächige Abschnitt zwei Auflagen im Sinne der vorliegenden Erfindung aus. Üblicherweise werden aber zur Verwirklichung der vorliegenden Erfindung wenigstens zwei voneinander getrennte und im Verhältnis zu der Gesamtfläche der Stromschiene relativ kleine erste und zwei zweite Auflagen durch die Stromschiene ausgebildet, die mit gegenüberliegenden Oberflächen der Leiterplatte zusammenwirken. Damit wird dem Umstand Rechnung getragen, dass die Stromschiene sich mitunter durch thermische und/oder mechanische Einflüsse relativ zu der Leiterplatte verformen kann. Die Befestigung der wenigstens einen Stromschiene an der Leiterplatte über wenigstens zwei Stützstellen an jeder der beiden Oberflächen der Leiterplatte soll hierbei eine gewisse Ausgleichsmöglichkeit schaffen, ohne die Leiterplatte selbst unter Spannung zu setzen.

Grundsätzlich können die Auflagen an sehr unterschiedlichen Stellen mit der Leiterplatte zusammenwirken. So können in der Leiterplatte Aussparungen vorgesehen sein, durch welche die Stromschiene von der einen zu der anderen Oberfläche der Leiterplatte geleitet wird. Bei einer Befestigung der Stromschiene am Rand der Leiterplatte ist es indes zu bevorzugen, die erste und die zweite Auflage der Stromschiene als Klaue auszubilden, die die Leiterplatte umgreift. Eine mit Klauen an der Leiterplatte kontaktierte Stromschiene kann zu ihrer Befestigung lediglich zwei beabstandet zueinander vorgesehene Klauen aufweisen und durch seitliches Anschieben an die Leiterplatte mit dieser befestigt und kontaktiert werden. Die Klaue umfasst üblicherweise zwei mit Abstand zueinander vorgesehene erste Auflagen und eine dazwischen vorgesehene zweite Auflage.

Der Seitenabstand der ersten Auflagen ist dabei vorzugsweise so gewählt, dass die zweite Auflage zwar mit einem gewissen geringen Materialverlust, der durch das Ausstanzen der Auflagen aus einem die Stromschiene bildenden Blechmaterial und Umbiegen der Auflagen zur Ausbildung eines der Dicke der Leiterplatte entsprechenden Klauenabstand begründet wird, gleichwohl aber im Wesentlichen unmittelbar benachbart zu der ersten Klaue vorgesehen ist. Die mit der Leiterplatte zusammenwirkenden Oberflächen der Auflagen können dabei zusätzlich so ausgeformt sein, dass die Auflagen zumindest an derjenigen Stelle, wo die Auflagen auch der elektrischen Kontaktierung zwischen der Stromschiene und der Leiterplatte dienen, einen durch Umformen ausgebildeten Vorsprung haben, der punktuell und dementsprechend in vorbestimmter Weise gegen die Oberfläche der Leiterplatte an einer dort vorgesehenen Leiterbahn anliegt. Eine solche durch Umformen ausgebildete Erhebung bewirkt auch, dass die Klaue beim Aufschieben auf die Leiterplatte geringfügig elastisch gegen die gegenüberliegenden Oberflächen der Leiterplatte angelegt wird. Hierdurch wird eine kraft- bzw. reibschlüssige Halterung der Stromschiene an der Leiterplatte erzielt, die für sich ausreichend sein kann, die Stromschiene an der Leiterplatte zu befestigen.

Es sollte aber beachtet werden, dass mit der vorliegenden Erfindung insbesondere lediglich eine Befestigung der einen oder sämtlicher Stromschienen an der Leiterplatte gelehrt wird, die zunächst zu Montagezwecken verwirklicht wird. Die so vormontierte Leiterplatte kann danach beispielsweise mit elektrischen und elektronischen Bauteilen bestückt werden. Danach kann beispielsweise durch Dampfphasenlöten eine dauerhafte und stoffschlüssige Verbindung der Bauelemente und der einen bzw. sämtlicher Stromschienen an der Leiterplatte erfolgen. Die fertig gestellte elektrische Heizvorrichtung hat danach eine oder mehrere Stromschienen, die durch Zusammenwirken von ersten und zweiten Auflagen mit den ersten und zweiten Oberflächen der Leiterplatte mit dieser zunächst reib-, kraft- und/oder formschlüssig verbunden sind, und zwar durch Verbindungselemente, die allein durch die Leiterplatte und die Stromschiene gebildet werden, und die darüber hinaus eine regelmäßig durch Löten bewirkte stoffschlüssige Verbindung zumindest in den Bereichen aufweist, in denen die Stromschiene auch elektrisch mit der Leiterbahn kontaktiert ist, d.h. mit der Leiterplatte verlötet sind. Dies lässt die Möglichkeit offen, dass erste und zweite Auflagen, die an der Stromschiene vorgesehen sind, lediglich der mechanischen Arretierung dienen, d.h. nicht elektrisch mit einer Leiterbahn der Leiterplatte kontaktiert sind und dort auch nicht mit der Leiterplatte verlötet sind.

Gemäß der vorliegenden Erfindung wird des Weiteren an der Leiterplatte wenigstens eine Aussparung vorgesehen, in der ein Leistungstransistor aufgenommen ist. Die wenigstens eine Kontaktschiene bildet in der Aussparung eine dort freiliegende Kontaktfläche aus, auf der der Leistungstransistor befestigt ist. Üblicherweise erfolgt diese Befestigung in elektrisch leitender Art, so dass zwischen der Stromschiene und dem Leistungstransistor über die Kontaktfläche eine elektrische Kontaktierung bewirkt wird. Die in der Leiterplatte vorgesehene Aussparung wird bei dieser bevorzugten Weiterbildung genutzt, die Stromschiene von der einen zu der anderen Oberfläche durch die Leiterplatte hindurch zu führen. Dementsprechend weist die Stromschiene bevorzugt benachbart zu der Kontaktfläche erste und zweite Auflagen auf. Die Leiterplatte wirkt daher auf einer Seite üblicherweise randnah zu der Aussparung mit einer ersten Auflage und einer zweiten Auflage zusammen. Die Aussparung kann eine randseitig offene U-förmige Aussparung sein. Bei dieser bevorzugten Weiterbildung werden üblicherweise Klauen vorgesehen, um die Stromschiene an der Leiterplatte im Bereich der Aussparung zu verbinden. Die Aussparung kann indes eine umfänglich von dem Material der Leiterplatte umgebene Aussparung sein, in welcher der Leistungstransistor aufgenommen ist.

Gemäß einer bevorzugten Weiterbildung der vorliegenden Erfindung hat die Stromschiene eine von der Leiterplatte abragende Kühlfahne, die derart bemessen ist, dass diese durch die Aussparung passt. Die Abstimmung der Abmessung der Kühlfahne auf die Abmessung der Ausnehmung erfolgt mit dem Ziel, die Kühlfahne durch die Aussparung hindurch seitlich die Leiterplatte überragend vorzusehen. Die Kühlfahne kann dabei in einer Richtung quer zu der Erstreckungsrichtung der Leiterplatte von dieser abragen. Üblicherweise ist die Kühlfahne aber so vorgesehen, dass sie die Leiterplatte auch seitlich überragt, so das eine die Kühlfahne anströmende Kühlluftströmung seitlich die Leiterplatte passieren kann. Es ist zwar grundsätzlich möglich, entsprechende Durchlässe für Luft auch innerhalb der Leiterplatte vorzusehen, um innerhalb der Hüllfläche der Leiterplatte vorgesehene Kühlfahnen mit Kühlluft anzuströmen. Im Hinblick auf eine möglichst kompakte Ausgestaltung der Leiterplatte wird indes einer Lösung der Vorzug gegeben, bei welcher die Kühlfahnen ganz oder teilweise außerhalb der Hüllfläche liegen, die die Leiterplatte umhüllt. Mit der vorliegenden Erfindung wird eine Ausrichtung der als Blechstreifen vorgesehenen Kühlfahnen parallel zu der Ebene der Leiterplatte als bevorzugt angesehen.

Eine gute Abstützung der Leiterplatte im Bereich der Kontaktfläche wird gemäß einer bevorzugten Weiterbildung der vorliegenden Erfindung dadurch geschaffen, dass die Stromschiene zwischen der Kühlfahne und der Kontaktfläche eine erste Anlage und benachbart zu der Kontaktfläche auf der der Kühlfahne gegenüberliegenden Seite eine kontaktflächennahe zweite Auflage ausbildet. Sofern in dieser allgemeinen Beschreibung zur Erläuterung unterschiedlicher Weiterbildungen auf erste und zweite Auflagen bzw. erste und zweite Oberflächen abgestellt wird, soll hiermit lediglich zum Ausdruck gebracht werden, dass es sich um unterschiedliche Seiten der Leiterbahn bzw. der mit diesen unterschiedlichen Seiten zusammenwirkenden Abschnitte der Stromschiene handelt. Mit diesem Verständnis ergibt sich aus der Weiterbildung der Vorteil, dass die Stromschiene üblicherweise unmittelbar benachbart zu der Aussparung mit der Leiterplatte zusammenwirkt, so dass die Stromschiene in den die Kontaktfläche für den Leistungstransistor ausbildenden Bereich in vorbestimmter Weise relativ zu der Leiterplatte fixiert ist. Durch zusätzliche Auflagen, insbesondere durch Auflagen, die an sämtlichen Randflächen neben der Aussparung an der ersten oder der zweiten Oberfläche der Leiterplatte anliegen, kann dieses Ziel in verbesserter Weise erreicht werden.

Gemäß einer bevorzugten Weiterbildung der vorliegende Erfindung sind mehrere Aussparungen vorzugsweise nebeneinander vorgesehen und die Kontaktschiene bildet mehrere Kontaktflächen aus, die jeweils in einer der Aussparungen freiliegen. Dabei sind benachbarte Kontaktflächen über einen eine zweite Auflage ausbildenden Verbindungssteg miteinander verbunden. Bei dieser bevorzugten Weiterbildung geht die Kühlfahne üblicherweise von der ersten Oberfläche ab und stützt sich an dieser ab. Durch den Verbindungssteg ist der Seitenabstand der jeweiligen Kontaktflächen genau vorgegeben, so dass die Stromschiene zuverlässig beim Durchführen der einzelnen Kühlfahnen durch die Aussparungen an der Leiterplatte montiert werden kann. Nach der Montage liegt der Verbindungssteg üblicherweise auf der zweiten Oberfläche der Leiterplatte, wodurch diese bereits mit hoher Genauigkeit positioniert ist.

Gemäß einer bevorzugten Weiterbildung der Erfindung erfolgt die Befestigung der Stromschiene jedenfalls auch über Rastelemente. Beispielsweise durch Einbringen der Stromschiene in die wenigstens eine Aussparung wird zunächst üblicherweise eine gewisse formschlüssige Positionierung der Stromschiene erreicht. Wenn darüber hinaus die Stromschiene zusätzlich durch ein oder mehrere Rastverbindungen gegenüber der Leiterplatte verrastet wird, ist eine hinreichende Positionierung und Befestigung der Stromschiene an der Leiterplatte geschaffen, die später lediglich durch wenige Lötverbindungen gesichert werden muss.

Die zuvor erwähnte Rastverbindung ist vorzugsweise durch einen Rastschenkel verwirklicht, der eine sich parallel und mit Abstand zu der zweiten Oberfläche erstreckende Rastschenkelbasis und eine sich im Wesentlichen rechtwinklig zu dieser Rastschenkelbasis erstreckende und eine Verriegelungsöffnung der Leiterplatte durchsetzende Rastschenkellasche umfasst. Diese Rastschenkellasche weist einen gegen die erste Oberfläche verriegelnden Rastnocken auf. Über die Rastschenkelbasis wird ein gewisser Abstand zu der Oberfläche der Leiterplatte geschaffen, um insbesondere die Rastschenkellasche mit einer Erstreckung im Wesentlichen rechtwinklig zu der Flächenerstreckung der Leiterplatte und mit Abstand zu übrigen Teilen der Stromschiene vorzusehen.

Eine sehr gute Festlegung der Stromschiene durch den Rastschenkel wird gemäß einer bevorzugten Weiterbildung erreicht, bei welcher der Rastschenkel einen Auflageschenkel ausbildet, der in Richtung auf die Leiterplatte umbogen ist und benachbart zu der Verriegelungsöffnung gegen die Leiterplatte anliegt. Der Anlageschenkel bildet dabei üblicherweise mit seinen durch Zurückschneiden gegenüber der Rastschenkellasche ausgebildeten stirnseitigen Ende eine erste Auflage aus, die mit der zweiten Oberfläche der Leiterplatte zusammenwirkt, wohingegen der Rastnocken gegen die erste Oberfläche verriegelt, so dass die Stromschiene im Bereich des Rastschenkels zwischen dem Anlageschenkel und dem Rastnocken durch den Rastschenkel umgriffen ist. Die Verriegelungsöffnung und die Rastschenkellasche sind dabei so aufeinander abgestimmt, dass die Rastschenkellasche nur geringfügig innerhalb der Verriegelungsöffnung beweglich ist, so dass die Stromschiene über den Rastschenkel mit hoher Genauigkeit relativ zu der Leiterplatte fixiert ist.

Gemäß einer weiteren bevorzugten Ausgestaltung der vorliegenden Erfindung geht der Rastschenkel von einem mit Abstand zu der Leiterplatte vorgesehenen Stromschienenbasisabschnitt ab, der über die kontaktflächennahe zweite Auflage die Kontaktfläche ausbildet. Diese Stromschiene ist daher vorzugsweise so ausgebildet, dass sich lediglich die wenigstens eine Kontaktfläche auf Höhe der Leiterplatte befindet, wohingegen der übrige innerhalb der Hüllfläche der Leiterplatte vorgesehene Bereich der Stromschiene nahezu ausschließlich mit Abstand zu der Leiterplatte vorgesehen ist. Der außerhalb der Hüllfläche vorgesehene Bereich der Stromschiene bildet die wenigstens eine Kühlfahne aus. Die entsprechende Stromschiene ist danach bestmöglich thermisch von der Leiterplatte isoliert und kann über nahezu ihre gesamte Fläche außer die Kontaktfläche(n) Wärme an umgebende Luft abgeben. Die bevorzugte Weiterbildung hat dabei insbesondere einen länglichen Stromschienen-Basisabschnitt, von dem kammartig üblicherweise mehrere Querstege abgehen, die zunächst die Kontaktflächen für die Leistungstransistoren und im weiteren Verlauf jeweils die Kühlfahnen ausbilden.

Im Hinblick auf eine gewisse Positionierung und Beabstandung der Stromschienenbasis, weist diese vorzugsweise durch Umformen des die Stromschiene bildenden Blechstreifens ausgeformte Aufagepunkte auf. Die Auflagepunkte befinden sich üblicherweise mittig an dem regelmäßig länglichen Stromschienen-Basisabschnitt und kontaktieren lediglich geringfügig, vorzugsweise punktuell die Leiterplatte. Durch diese Auflagepunkte ist die Stromschiene mit Abstand zu der Leiterplatte an dieser abgestützt. Die Auflagepunkte befinden sich dabei vorzugsweise auf Höhe der Querstege.

Sämtliche zuvor beschriebenen Funktionsflächen einer Stromschiene werden üblicherweise durch Stanzen, Biegen oder Prägen eines Blechstreifens ausgeformt.

Gemäß einer bevorzugten Weiterbildung der vorliegenden Erfindung weist die Leiterplatte mehrere nebeneinander vorgesehene Aufnahmeschlitze für Kontaktfahnen auf, die den Heizblock elektrisch mit der Leiterplatte verbinden. Im Hinblick auf eine möglichst kompakte Ausgestaltung der Leiterplatte überdeckt der Stromschienen-Basisabschnitt diese Aufnahmeschlitze ganz oder teilweise. Dies bedeutet, dass die Aufnahmeschlitze bei einer orthogonalen Draufsicht auf die Leiterplatte von derjenigen Seite, auf der sich die Stromschiene befindet, die Aufnahmeschlitze jedenfalls nicht vollständig sichtbar sind. Üblicherweise erstreckt sich der Stromschienen-Basisabschnitt rechtwinklig zu der Längserstreckung der Aufnahmeschlitze und lässt nicht mehr als 30 % der Länge der Aufnahmeschlitze frei.

Die erfindungsgemäße elektrische Heizvorrichtung hat vorzugsweise wenigstens zwei Stromschienen, die benachbart zueinander angeordnete, sich rechtwinklig zu der Leiterplatte ausgerichtete Anschlusslaschen ausbilden. Jede der beiden Stromschienen bildet dabei regelmäßig eine einzige Anschlusslasche aus. Von dieser üblichen Ausgestaltung unterscheidet sich die Weiterbildung dadurch, dass an wenigstens einer der Anschlusslaschen ein Kontaktzungenstück befestigt ist. Bei dieser bevorzugten Weiterbildung ist jede Stromschiene zumindest zweistückig ausgebildet. Durch das zunächst separat hergestellte Kontaktzungenstück kann besonderen Maßvorgaben auf Seiten eines Gegensteckers, der an die Kontaktzungenstücke angeschlossen wird, Rechnung getragen werden. Mit anderen Worten kann das Kontaktzungenstück mit anderem Querschnitt erstellt werden als die Stromschiene. Des Weiteren können die Stromschiene einerseits und das Kontaktstück andererseits aus unterschiedlichen Materialien hergestellt und/oder mit speziellen Beschichtungen vorgesehen sein. Das Kontaktzungenstück hat dabei vorzugsweise eine Beschichtung aus Zinn, Silber oder Nickel. Die Stromschiene und/oder das Kontaktzungenstück können aus Kupfer, einer Kupferlegierung oder auch einer Messinglegierung ausgeformt sein. Denkbar ist auch die Ausgestaltung der Stromschiene und/oder des Kontaktzungenstücks aus Aluminium oder einer Aluminiumlegierung mit einer lötfähigen Oberfläche, z. B. vernickelt.

Mit Blick auf eine zuverlässige Positionierung der Steuervorrichtung in dem Gehäuse wird gemäß einer bevorzugten Weiterbildung der vorliegenden Erfindung vorgeschlagen, das Gehäuse mit einer Gehäusebasis auszubilden, in der der Heizblock und die Kontaktfahnen aufgenommen sind und welches mit die Kontaktfahnen fassenden und von den Kontaktfahnen geringfügig überragten Kontaktfahnenaufnahmen verbunden ist. Auf diesen Kontaktfahnenaufnahmen liegt die Leiterplatte auf. Die Gehäusebasis ist üblicherweise mittels Kunststoffspritzgießen hergestellt, wobei die Kontaktfahnenaufnahmen vorzugsweise einstückig mittels Spritzgießen an der Gehäusebasis vorgesehen sind. Die Gehäusebasis ist üblicherweise durch einen einheitlichen Gehäusedeckel verschlossen, der im Bereich des Heizblocks ein oder mehrere Durchlassöffnungen für die den Heizblock durchströmende Luft freilässt, des weiteren separate Kühlfahnenaufnahmeöffnungen ausspart, die sich zwischen dem Heizblock und einem Gehäusebereich erstrecken, der die Steuervorrichtung aufnimmt, und einen weiteren Abschnitt umfasst, der ein einteilig an der Gehäusebasis ausgebildetes Steuerungsgehäuse verschließt.

Die Kontaktfahnenaufnahmen sind dabei vorzugsweise zu einer Teilungsebene des Gehäuses offen, so dass der Heizblock zusammen mit den Kontaktfahnen in die Gehäusebasis eingelegt werden kann. Quer zu der Ebene des Heizblocks werden die Kontaktfahnenaufnahmen geringfügig von den Kontaktfahnen überragt. Da in diesem Bereich auch die Leiterplatte aufliegt, ist die Durchdringung der Leiterplatte durch die Kontaktfahne exakt vorbestimmt.

Zur Lösung des nebengeordneten Aspekts der vorliegenden Erfindung wird mit dieser eine Leiterplatte mit den Merkmalen von Anspruch 15 angegeben.

Die vorliegende Erfindung wird nachfolgend unter Bezugnahme auf das Ausführungsbeispiel in Verbindung mit der Zeichnung näher erläutert. In dieser zeigen:
- Figur 1: Eine perspektivische Seitenansicht eines Ausführungsbeispiels einer elektrischen Heizvorrichtung bei abgenommenem Gehäusedeckel;
- Figur 2: Wesentliche Bestandteile der in Figur 1 gezeigten Steuervorrichtung bei einer perspektivischen Seitenansicht auf eine erste Oberfläche der Leiterplatte der Steuervorrichtung;
- Figur 3: Eine Ansicht gemäß Figur 2 auf eine zweite Oberfläche der Leiterplatte;
- Figur 4: Eine perspektivische Seitenansicht auf die zweite Oberfläche der Leiterplatte von der im Vergleich zu Figur 3 gegenüberliegenden Längsseite der Leiterplatte; und
- Figur 5: Eine perspektivische Darstellung in etwa gemäß Figur 2 nach Fertigstellung der Leiterplatte.

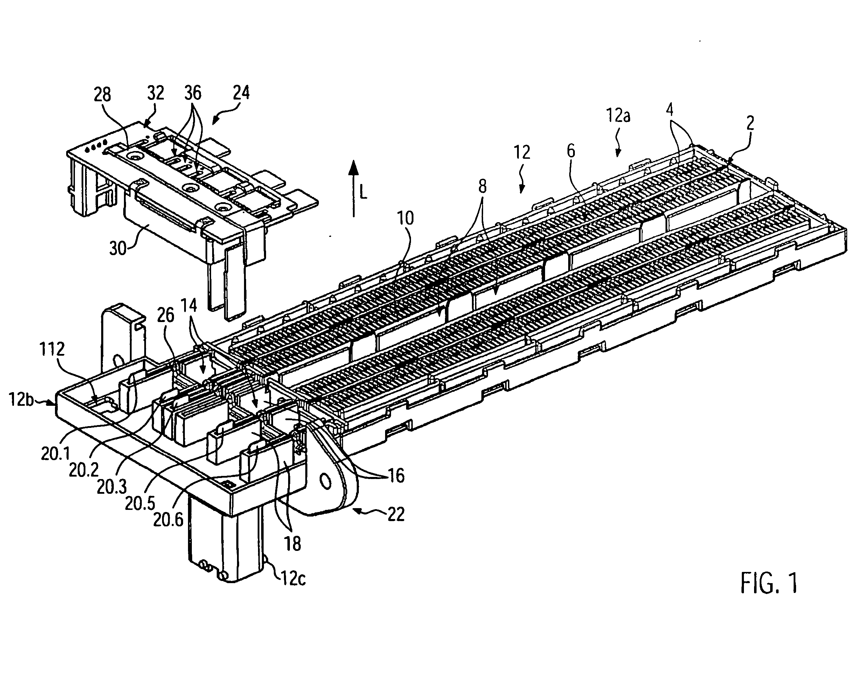

Die Figur 1 zeigt eine perspektivische Seitenansicht auf ein Ausführungsbeispiel einer elektrischen Heizvorrichtung mit einem Heizblock 2, der einen geschichteten Aufbau bestehend aus mehreren wärmeabgebenden Elementen 4 mit zwischen den wärmeabgebenden Elementen 4 vorgesehenen wärmeerzeugenden Elementen 6 umfasst. Zur besseren grafischen Darstellung der Elemente des Heizblocks 2 sind Teile des Heizblocks 2 im mittleren Bereich des Ausführungsbeispiels weggelassen worden, so dass mehrere in einer Ebene des Schichtaufbaus hintereinander vorgesehene PTC-Elemente 8 erkennbar sind sowie ein Blechband 10, an dem diese PTC-Elemente 8 wärmeleitend und elektrisch leitend anliegen. Nach der Montage ist auf der anderen Seite des Blechbandes 10 ein weiteres Blechband vorgesehen, so dass die PTC-Elemente 8 über die beiden Blechbänder 10 kontaktiert sind. Der Heizblock 2 ist bei dem gezeigten Ausführungsbeispiel unter Federspannung in einem Gehäusebasisteil 12 geklemmt, so dass alle Lagen des Heizblocks 2 durch die Kraft der Federeinrichtung gegeneinander angelegt sind.

Das Gehäuseunterteil 12 umfasst ein Heizblockgehäuseteil 12a und ein Steuerungsgehäuseteil 12b, die einstückig miteinander vorgesehen sind und zwischen denen Kühlfahnenaufnahmeöffnungen 14 zwischen die beiden Gehäuseteile 12a, 12b verbindende Stege 16 ausgeformt sind. Die Stege 16 fluchten mit Kontaktfahnenaufnahmen 18, die in dem Steuerungsgehäuseteil 12b vorgesehen sind. Dort sind die Kontaktfahnenaufnahmen 18 lediglich oberseitig, d.h. in Richtung der Luftströmung, gekennzeichnet mit dem Pfeil "L", offen sind.

Ausgewählte Blechbänder 10 des Heizblocks 2 sind durch die Stege 16 bis in die Kontaktfahnenaufnahmen 18 hindurchgeführt und bilden dort die mit Bezugszeichen 20.1 - 20.3 und 20.4 sowie 20.5 gekennzeichneten Kontaktfahnen aus. Die Kontaktfahnen 20 überragen geringfügig die Kontaktfahnenaufnahmen 18, d.h. liegen über der durch das Gehäuseunterteil 12 vorgegebenen Teilungsebene frei. Diese Teilungsebene wird im Übrigen auch überragt durch Teile eines Befestigungsflansches 22 für die elektrische Heizvorrichtung, welcher in etwa auf Höhe des Steuerungsgehäuseteils 12b vorgesehen ist.

Das in Figur 1 gezeigte Gehäuseunterteil 12 wird nach Montage sämtlicher Komponenten der elektrischen Heizvorrichtung mit einem Gehäusedeckel verschlossen, der auch den dann das Gehäuse umfänglich umgebenden Befestigungsflansch 22 komplettiert. Der Gehäusedeckel bildet sowohl eine Abdeckung für den Heizblock 2 wie auch für eine mit Bezugszeichen 24 gekennzeichnete Steuervorrichtung aus und schließt diese dicht ein. Das Steuerungsgehäuse 12b ist über eine an das Gehäuseunterteil 12 angespritzte Dichtung 26 im Bereich der Durchtrittsöffnungen für die Kontaktfahnen 10 zu einem Lüftungskanal abgedichtet, der die zu erwärmende Luftströmung L führt.

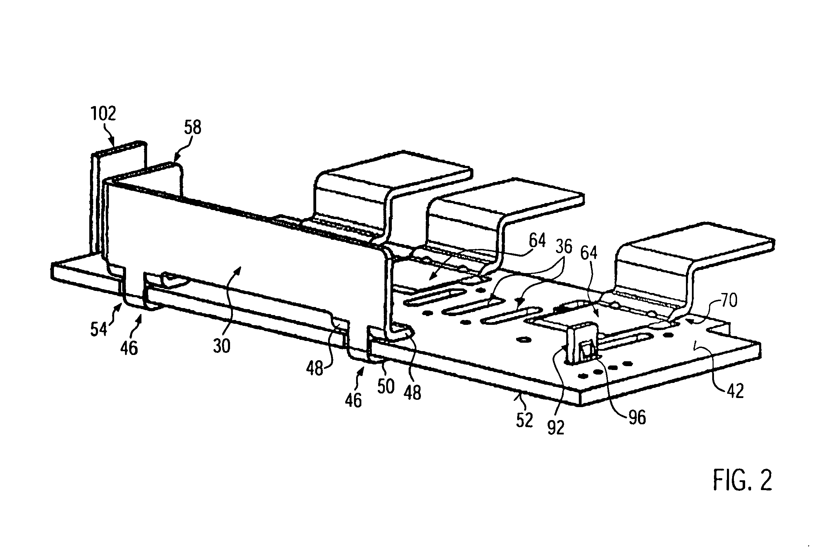

Nachfolgend wird die Steuervorrichtung 24 insbesondere unter Bezugnahme auf die Figuren 2 bis 5 näher erläutert.

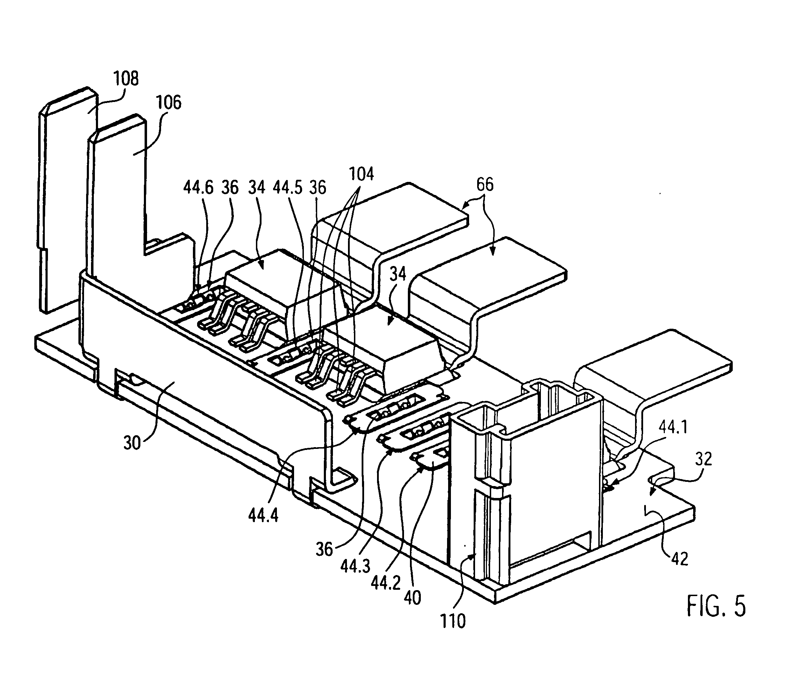

Die Steuervorrichtung 24 hat zwei Stromschienen 28, 30, die auf einer Leiterplatte 32 montiert sind. Die Leiterplatte 32 trägt Bauelemente beispielsweise in Form von Leistungstransistoren 34 (vgl. Figur 5), die über durch die Leiterplatte 32 ausgebildete Leiterbahnen kontaktiert sind. In der Leiterplatte 32 sind mehrere Aufnahmeschlitze 36 parallel zueinander und auf gleicher Höhe ausgespart. Den Aufnahmeschlitzen 36 zugeordnet sind Kontaktelemente 40 mit in die Aufnahmeschlitze 36 einragenden Federstegen auf der Leiterplatte 32 montiert. Die Kontaktelemente 40 haben hierzu einen Flansch, der auf einer im Folgenden als erste Oberfläche 42 bezeichneten Oberfläche der Leiterplatte 32 aufliegt (vgl. Figur 5). Die Kontaktelemente 40 bilden elektrische Anschlusselemente 44.1 - 44-6 für Leiterbahnen der Leiterplatte 32 aus.

Während Figur 5 die Leiterplatte 32 nach Verlöten sämtlicher Funktionselemente 28, 30, 34, 44 mittels Dampfphasenlöten zeigt, offenbaren die Figuren 2 - 4 einen Zwischenschritt bei der Herstellung der Leiterplatte 32 und verdeutlichen die mit der Erfindung vorgeschlagene, im Grunde formschlüssige Anbindung der Stromschienen 28, 30 an die Leiterplatte 32 bis zum Verlöten der Stromschienen 28, 30 mit der Leiterplatte 32.

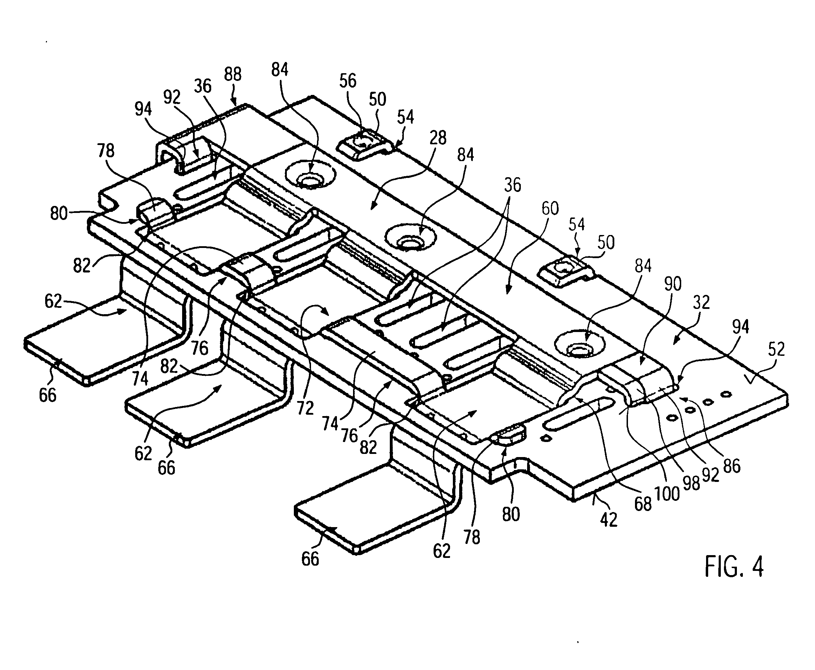

Die im Folgenden als erste Stromschiene 30 bezeichnete Stromschiene erstreckt sich im Wesentlichen rechtwinklig zu der Leiterplatte 32 und ist randseitig hierzu vorgesehen. Die erste Stromschiene 30 überragt die erste Oberfläche 42 der Leiterplatte 32. Durch Stanzen und Biegen sind an der ersten Stromschiene 30 zwei Klauen 46 ausgebildet, die die Leiterplatte 32 umgreifen. Jede Klaue 46 umfasst zunächst durch Schneiden freigeschnittene Stege, von denen die beiden Äußeren durch Umbiegen als erste Klauenauflagen 48 ausgeformt sind, wohingegen der mittlere, längere Steg durch Umbiegen zu einer zweiten Klauenauflage 50 umgeformt ist. Die ersten und zweiten Klauenauflagen 48, 50 erstrecken sich parallel zueinander und parallel zu der ersten Oberfläche 42 bzw. einer zweiten Oberfläche 52 der Leiterplatte 32. Wie die Figuren 2 und 4 erkennen lassen, ist die Leiterplatte 32 mit zwei Klauenaussparungen 54 versehen. Jede der Klauenaussparungen 54 nimmt den die zweite Klauenauflagen 50 ausbildenden Steg in sich auf. Hierdurch ist die erste Stromschiene 30 in ihrer Längsrichtung positioniert und formschlüssig relativ zu der Leiterplatte 32 gehalten. Wie sich Figur 4 entnehmen lässt, ist die der Leiterplatte 32 abgewandte Rückseite der zweiten Klauenauflage 50 durch Umformen mit einer Vertiefung 56 versehen, die auf der der Leiterplatte 32 zugewandten Seite eine Kontaktwölbung ausformt, über welche die erste Stromschiene 30 mit an der zweiten Oberfläche 52 der Leiterplatte 32 vorgesehen Leiterbahnen kontaktiert ist. Beim Aufschieben der ersten Stromschiene 30 auf die Leiterplatte 32 gleitet die Leiterplatte 32 randseitig gegen Schrägflächen, die durch diese Kontaktwölbungen ausgebildet werden, so dass die Klauen 46 elastisch gegen die Leiterplatte 32 vorgespannt angelegt sind.

Das in Figur 2 hintere Ende der ersten Stromschiene 30 ist rechtwinklig umbogen und bildet eine Anschlusslasche 58 aus, die die Leiterplatte 32 überragt.

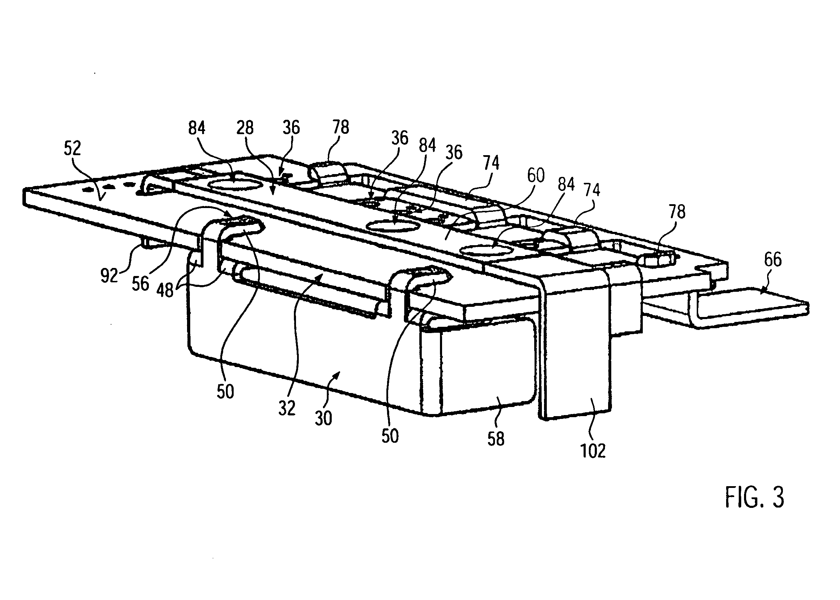

Unter Bezugnahme insbesondere auf die Figuren 3 und 4 werden nachfolgend wesentliche Elemente der zweiten Stromschiene 28 beschrieben. Diese Stromschiene 28 ist aus einem zunächst kammartig ausgeschnittenen Blechstreifen gebildet und hat eine sich parallel zu der Längserstreckung der Leiterplatte 32 erstreckende Stromschienenbasis 60, von der drei Stege 62 rechtwinklig abgehen. Die Stege 62 bilden drei sich parallel zu der Leiterplatte 32 erstreckende Bereiche aus, die durch Umbiegen des Blechstreifens geformt sind. Ein erster relativ kurzer Bereich liegt höhengleich zu der Ebene der Stromschienenbasis 60 und geht durch zweifaches Umbiegen in eine Kontaktfläche 64 über, die die erste Oberfläche der Leiterplatte 32 geringfügig überragt und sich parallel zu ihr erstreckt (vgl. Figur 2). Schließlich ist endseitig der Stege 62 durch mehrfaches Umbiegen eine sich parallel zu der Leiterplatte 32 erstreckende Kühlfahne 66 ausgeformt, die die Leiterplatte 32 überragt und sich mit einem Abstand zu der ersten Oberfläche 42 erstreckt. Zwischen der Kontaktfläche 64 und der Stromschienenbasis 60 bildet jeder Steg innere zweite Auflagen 68 aus, die mit der zweiten Oberfläche 52 zusammenwirken, d.h. sich dort abstützen. Am Übergang zwischen der Kontaktfläche 64 und der Kühlfahne 66 ist durch Umbiegen der Stege 62 eine äußere erste Auflage 70 ausgeformt, die sich nahe des Leiterplattenrandes auf der ersten Oberfläche 42 der Leiterplatte 32 abstützen (vgl. insbesondere Figur 2).

Die Kontaktflächen 64 befinden sich in der einer an der Leiterplatte 32 ausgebildeten Aussparungen 72. Zwischen den Aussparungen 72 bildet das Blechmaterial der zweiten Stromschiene 28 Verbindungsstege 74 aus, die sich quer zu den Stegen 62 erstrecken und die Kontaktflächen 64 miteinander verbinden. Diese Verbindungsstege 74 bilden sich quer erstreckende zweite Auflagen 76 aus, die mit der zweiten Oberfläche 52 der Leiterplatte 32 zusammenwirkt. In Verlängerung dieser Verbindungsstege 74 sind durch das Blechmaterial die Kontaktflächen 64 außenseitig überragende Auflagestege 78 ausgeformt, die aussparungsnahe zweite Auflagen 80 ausbilden, die mit der zweiten Oberfläche 52 zusammenwirken. Zur Aufnahme der Verbindungsstege 74 und der Auflagestege 78 sind die Aussparungen 72 für die Kontaktflächen 64 an ihren gegenüberliegenden Längsrändern mit Stegaussparungen 82 versehen.

Auf Höhe der Stege 62 sind an der Stromschienenbasis 60 durch lokales Umformen Auflagepunkte 84 ausgebildet, die sich auf der zweiten Oberfläche 52 der Leiterplatte 32 abstützen. Dadurch ist die Stromschienenbasis 60 mit Abstand zu der zweiten Oberfläche 52 der Leiterplatte 32 beabstandet. In Längsrichtung der Stromschienenbasis 60 bildet das Blechmaterial der zweiten Stromschiene 28 Rastschenkel 86, 88 aus.

Der in Figur 4 vorne gezeigte Rastschenkel 86 hat eine sich in der Ebene der Stromschienenbasis 60 erstreckende Rastschenkelbasis 90, von der zwei rechtwinklig umbogene Segmente abgehen. Ein längeres Segment bildet eine Rastschenkellasche 92 aus, die um 90° gegenüber der Rastschenkelbasis umbogen ist und eine Verriegelungsöffnung 94 durchsetzt, die in der Leiterplatte 32 ausgespart ist. Das freie Ende der Rastschenkellasche ist mit einem Rastnocken 94 versehen, der durch Ausstanzen und Umbiegen des Blechmaterials ausgeformt ist und von der Rastschenkellasche 92 absteht und die erste Oberfläche 42 übergreift, so dass der Rastschenkel 86 gegenüber der Leiterplatte 32 unverlierbar gesichert ist. Ein anderer Teil der Rastschenkelbasis hat eine kürzere Länge als die Rastschenkellasche 92 und ist ebenfalls um 90° umbogen zur Ausbildung eines Anlageschenkels 98, dessen stirnseitiges Ende sich parallel zu der zweiten Oberfläche 52 der Leiterplatte 32 erstreckt und dort eine Rastauflage 100 ausbildet, so dass die Leiterplatte 32 zwischen der Rastauflage 100 und/oder dem Rastnocken 94 zur Anlage kommt. In entsprechender Weise ist der Rastschenkel 88 ausgebildet, lediglich mit dem Unterschied, dass die Rastschenkelbasis 90 nicht an dem freien Ende der Stromschienenbasis 60 ausgebildet ist, sondern zunächst durch Freischneiden eines sich parallel zu dieser Rastschenkelbasis 90 erstreckenden Blechstreifens nach innen, d.h. zur Mitte der Stromschienenbasis 60 ausgeschnitten und dann umbogen und gestanzt ist. An dieser Seite ist das freie Ende der Stromschienenbasis 60 rechtwinklig umbogen zur Ausbildung einer Plus-Anschlusslasche 102 (vgl. Figuren 2 und 3).

Zur Montage des in den Figuren 2 bis 4 gezeigten Zwischenerzeugnisses werden zunächst die beiden Stromschienen 28, 30 durch Stanzen und Biegen in der beschriebenen Weise hergestellt. Die zweite Stromschiene 30 wird seitlich auf die Leiterplatte 32 aufgeschoben. Sie umgreift danach die Leiterplatte 32 kraftschlüssig und ist formschlüssig innerhalb der Klauenaussparungen 54 gehalten. Die elastische Vorspannung innerhalb der Klauen 46 sichert die Stromschiene 30 gegenüber der Leiterplatte 32.

Die andere Stromschiene 28 wird zunächst mit ihren die Kühlfahnen 66 bildenden freien Enden durch die jeweiligen Aussparungen 72 hindurchgeführt. Dabei wird die zweite Stromschiene 28 gegenüber der Leiterplatte 32 schräg positioniert geführt. Dabei kommen die Auflagestege 78 bzw. die Verbindungsstege 74 in die entsprechenden Stegaussparungen 82 der Leiterplatte 32. Die zweite Stromschiene 28 ist danach formschlüssig gegenüber der Leiterplatte 32 in Einführrichtung gehalten. Danach wird die Stromschiene 28 in Richtung auf die Leiterplatte 32 verschwenkt. Hierbei greifen die Rastschenkellaschen 92 in die Verriegelungsöffnungen 94, bis die Leiterplatte an den Rastschenkeln 86, 88 verriegelt ist. Danach sind beide Stromschienen 28, 30 durch Zusammenwirken der ersten und zweiten Auflagen formschlüssig an der Leiterplatte 32 gehalten.

Die in dieser Weise vormontierte Leiterplatte 32 wird dann üblicherweise an die so genannte Elektronikfertigung weitergeleitet, wo mittels Dampfphasenlöten die Bauelemente 34 auf die Kontaktflächen 64 aufgebracht werden, um die Leistungstransistoren 34 mit guter Wärmeleitung mit den Kühlfahnen 66 zu verbinden. Kontaktfüße 104 der Leistungstransistoren 34 werden mit Leiterbahnen der Leiterplatte 32 verlötet. Auch die Stromschienen 28, 30 werden jedenfalls an ihren Kontaktstellen zu Leiterbahnen der Leiterplatte 32 mit dieser verlötet. Schließlich werden Kontaktzungenstücke 106, 108 mit den Anschlussfahnen 58, 102 verlötet. Diese Kontaktzungenstücke 106, 108 sind auf einen weiblichen Stecker zum elektrischen Anschluss des Ausführungsbeispiels an das 12-V-Bordnetz entsprechend angepasst. Des weiteren wird in der Elektronikfertigung ein Steuerungssteckergehäuse 110 auf der Leiterplatte 32 montiert und innerhalb des Steuersteckergehäuses 110 Steckkontaktelemente für den Anschluss eines Steuerkabels an die Leiterplatte 32 elektrisch leitend mit der Leiterplatte 32 vorgesehen.

Danach wird die so vorbereitete Steuervorrichtung 24 in das Steuerungsgehäuseteil 12a eingesetzt. Dabei werden die einzelnen Kontaktfahnen 20.1 bis 20.6 in die zugehörigen elektrischen Anschlusselemente 44.1 bis 44.6 eingeführt. Die Flansche der zugeordneten Kontaktelemente 40 liegen danach auf dem Rand der Kontaktfahnenaufnahmen 18 an. Eine untere Auflage mit dem Boden des Steuerungsgehäuseteils 12b wird durch die freie Stirnseite der ersten Stromschiene 30 gebildet. Auf diese Weise ist die Steuervorrichtung 24 in dem Steuerungsgehäuseteil 12b positioniert. Die Kühlfahnen 66 überragen das Steuerungsgehäuseteil 12b und liegen in den Kühlfahnenaufnahmeöffnungen frei. Die Kontaktzungenstücke 106, 108 befinden sich in einem an dem Gehäuseunterteil 12 ausgesparten Leistungssteckergehäuse 12c. Das Steuerungssteckergehäuse 110 durchragt eine im Boden des Steuerungsgehäuseteils 12b ausgesparte Öffnung 112.

Die Steuervorrichtung 24 ist in ihren die Oberfläche des Gehäuseunterteils 12 überragenden Bereich relativ platzsparend ausgebildet, da die zweite Stromschiene 28 die Leiterplatte 32 nur geringfügig überragt, gleichwohl aber die Aufnahmeschlitze 36 in Längsrichtung der Schichten des Heizblocks 2 zumindest teilweise überdeckt, so das die Steuervorrichtung 24 auch in Längsrichtung der Lagen des Heizblocks 2 kompakt gebildet ist.

Die erste Stromschiene 28 bildet den Pluspol der Bestromung für die elektrische Heizvorrichtung; die erste Stromschiene 30 den Massepol aus. Die Leistungstransistoren 34 schalten auf der Masseseite, an welche die elektrischen Anschlusselemente 44.1, 44.4 und 44.5 angeschlossenen sind. Die anderen elektrischen Anschlusselemente 44.2, 44.3 und 44.6 sind der Plus-Stromschiene elektrisch zugeordnet.

### Bezugszeichenliste

- 2: Heizblock
- 4: wärmeabgebendes Element
- 6: wärmeerzeugendes Element
- 8: PTC-Element
- 10: Blechband
- 12: Gehäuseunterteil
- 12a: Heizblockgehäuseunterteil
- 12b: Steuerungsgehäuseteil
- 12c: Leistungssteckergehäuseteil
- 14: Kühlfahnenaufnahmeöffnung
- 16: Stege
- 18: Kontakftfahnenaufnahme
- 20: Kontaktfahnen
- 22: Befestigungsflansch
- 24: Steuervorrichtung
- 26: Dichtung
- 28: zweite Stromschiene
- 30: erste Stromschiene
- 32: Leiterplatte
- 34: Leistungstransistor
- 36: Aufnahmeschlitz
- 40: Kontaktelement
- 42: erste Oberfläche
- 44.1 - 44.6: elektrisches Anschlusselement
- 46: Klaue
- 48: erste Klauenauflage
- 50: zweite Klauenauflage
- 52: Oberfläche
- 54: Klauenaussparung
- 56: Vertiefung
- 58: Anschlusslasche
- 60: Stromschienenbasis
- 62: Steg
- 64: Kontaktfläche
- 66: Kühlfahne
- 68: innere zweite Auflage
- 70: äußere erste Auflage
- 72: Aussparung
- 74: Verbindungssteg
- 76: zweite Auflage
- 78: Auflagesteg
- 80: zweite Auflage
- 82: Stegaussparung
- 84: Auflagepunkt
- 86: Rastschenkel
- 88: Rastschenkel
- 90: Rastschenkelbasis
- 92: Rastschenkellasche
- 94: Verriegelungsöffnung
- 96: Rastnocke
- 98: Anlageschenkel
- 100: Rastauflage
- 102: Plus-Anschlusslasche
- 104: Kontaktfuß
- 106: Kontaktzungenstück
- 108: Kontaktzungenstück
- 110: Steuerungssteckergehäuse
- 112: Öffnung
- L: Strömungsrichtung Luft

## Patentansprüche

1. Elektrische Heizvorrichtung, insbesondere Heizvorrichtung für ein Kraftfahrzeug, mit einem Heizblock (2) umfassend wenigstens ein wärmeabgebendes Element (4), welches wärmeleitend mit einem wenigstens ein PTC-Element (8) umfassenden wärmeerzeugenden Element (6) verbunden ist, ein Gehäuse (12) zur Aufnahme des Heizblocks (2) und eine in baulicher Einheit mit dem Heizblock (2) vorgesehene Steuervorrichtung (24), wobei die Steuervorrichtung eine Leiterplatte (32) aufweist, die mit Bauelementen (34) bestückt und mit wenigstens einer Stromschiene (28, 30) kontaktiert ist,
**dadurch gekennzeichnet, dass** die Stromschiene (28, 30) erste Auflagen (48, 70) und zweite Auflagen (50, 68, 76, 80, 82, 100) ausbildet, wobei die ersten Auflagen (48, 70) mit einer ersten Oberfläche (42) der Leiterplatte (32) und die zweiten Auflagen (50, 68, 76, 80, 82, 100) mit einer zweiten Oberfläche (52) der Leiterplatte (32) zusammenwirken und
dass die Leiterplatte (32) wenigstens eine Aussparung (72) aufweist, dass die Stromschiene (28) eine in der Aussparung (72) freiliegende Kontaktfläche (64) ausformt, auf der ein Leistungstransistor (34) befestigt ist und
dass die Stromschiene benachbart zu der Kontaktfläche (64) die ersten und zweiten Auflagen (70; 68, 76, 80) aufweist.

2. Elektrische Heizvorrichtung nach Anspruch 1, **dadurch gekennzeichnet, dass** die ersten und zweiten Auflagen (48; 50) der Stromschiene (30) eine Klaue (46) ausbilden, die die Leiterplatte (32) umgreift.

3. Elektrische Heizvorrichtung nach Anspruch 2, **dadurch gekennzeichnet, dass** die Klaue (46) zwei mit Abstand zueinander vorgesehene erste Auflagen (48) und eine dazwischen vorgesehene zweite Auflage (50) umfasst.

4. Elektrische Heizvorrichtung nach einem der vorherigen Ansprüche, **gekennzeichnet durch** eine von der Leiterplatte (32) abragende und **durch** die Stromschiene (28) ausgebildete Kühlfahne (66), die derart bemessen ist, dass diese **durch** die Aussparung (72) passt.

5. Elektrische Heizvorrichtung nach Anspruch 4, **dadurch gekennzeichnet, dass** die Stromschiene (28) zwischen der Kühlfahne (66) und der Kontaktfläche (64) eine erste Auflage (70) und benachbart zu der Kontaktfläche (64) auf der der Kühlfahne (66) gegenüberliegenden Seite eine kontaktflächennahe zweite Auflage (68) ausbildet.

6. Elektrische Heizvorrichtung nach einem der vorherigen Ansprüche, **dadurch gekennzeichnet, dass** mehrere Aussparungen (72) vorgesehen sind und dass die Stromschiene (28) mehrere Kontaktflächen (64) ausbildet, die jeweils in einer der Aussparungen (72) freiliegen und dass benachbarte Kontaktflächen (64) über einen eine zweite Auflage (76) ausbildenden Verbindungssteg (74) miteinander verbunden sind.

7. Elektrische Heizvorrichtung nach einem der vorherigen Ansprüche, **dadurch gekennzeichnet, dass** die Stromschiene (28) einen Rastschenkel (86, 88) aufweist, der eine sich parallel und mit Abstand zu der zweiten Oberfläche (52) erstreckende Rastschenkelbasis (90) und eine sich im Wesentlichen rechtwinklig zu der Rastschenkelbasis (90) erstreckende und eine Verriegelungsöffnung (94) der Leiterplatte (32) durchsetzende Rastschenkellasche (92) umfasst, welche einen gegen die erste Oberfläche (42) verriegelnden Rastnocken (96) aufweist.

8. Elektrische Heizvorrichtung nach Anspruch 7, **dadurch gekennzeichnet, dass** der Rastschenkel (86) einen Anlageschenkel (98) aufweist, der in Richtung auf die Leiterplatte (32) umbogen ist und benachbart zu der Verriegelungsöffnung (94) gegen die Leiterplatte (32) anliegt.

9. Elektrische Heizvorrichtung nach Anspruch 7 oder 8, **dadurch gekennzeichnet, dass** der Rastschenkel (86) von einem mit Abstand zu der Leiterplatte (32) vorgesehenen Stromschienenbasisabschnitt (60) abgeht, der über die kontaktflächennahe zweite Auflage (68) die Kontaktfläche (64) ausbildet.

10. Elektrische Heizvorrichtung nach Anspruch 9, **dadurch gekennzeichnet, dass** die Stromschienenbasis (60) durch Umformen eines die Stromschiene (28) bildenden Blechstreifens ausgeformte Anlagepunkte (84) mit Abstand zu der Leiterplatte (32) an dieser abgestützt ist.

11. Elektrische Heizvorrichtung nach Anspruch 9 oder 10, **dadurch gekennzeichnet, dass** die Leiterplatte (32) mehrere nebeneinander vorgesehene Aufnahmeschlitze (36) für Kontaktfahnen (20) aufweist, die den Heizblock (2) elektrisch mit der Leiterplatte (32) verbinden und die von der Stromschienenbasis (60) zumindest teilweise überdeckt sind.

12. Elektrische Heizvorrichtung nach einem der vorherigen Ansprüche, **dadurch gekennzeichnet, dass** wenigstens zwei Stromschienen (28, 30) vorgesehen sind, die benachbart zueinander angeordnete und rechtwinklig zu der Leiterplatte (32) ausgerichtete Anschlussfahnen (58, 102) ausbilden, und dass an wenigstens einer der Anschlusslaschen (68, 102) ein Kontaktzungenstück (106, 108) befestigt ist.

13. Elektrische Heizvorrichtung nach einem der vorherigen Ansprüche, **dadurch gekennzeichnet, dass** das Gehäuse eine Gehäusebasis (12) umfasst, in der der Heizblock (2) und die Kontaktfahnen (20) aufgenommen sind und welche mit die Kontaktfahnen (20) fassenden und von den Kontaktfahnen (20) geringfügig überragten Kontaktfahnenaufnahmen (18) verbunden ist, auf denen die Leiterplatte (32) aufliegt.

## Claims

1. Electric heating device, particularly heating device for an automotive vehicle, comprising a heating block (2) including at least one heat-emitting element (4) which is heat conductively-connected to a heat-generating element (6) including at least one PCT element (8), a housing (12) for accommodating the heating block (2) and a control device (24) provided in a structural unit with the heating block (2), the control device comprising a printed circuit board (32) which is equipped with components (34) and is contacted with at least one busbar (28, 30),
**characterized in that** the busbar (28, 30) forms first supports (48, 70) and second supports (50, 68, 76, 80, 82 100), wherein the first supports (48, 70) cooperate with a first surface (42) of the printed circuit board (32) and the second supports (50, 68, 76, 80, 82, 100) cooperate with a second surface (52) of the printed circuit board (32), and
that the printed circuit board (32) comprises at least one recess (72), that the busbar (28) shapes a contact surface (64) which is exposed in the recess (72) and on which a power transistor (34) is mounted, and
that the busbar next to the contact surface (64) comprises the first and second supports (70; 68, 76, 80).

2. Electric heating device according to claim 1, **characterized in that** the first and second supports (48; 50) of the busbar (30) form a claw (46) which grips around the printed circuit board (32).

3. Electric heating device according to claim 2, **characterized in that** the claw (46) comprises two spaced-apart first supports (48) and an interposed second support (50).

4. Electric heating device according to any one of the preceding claims, **characterized by** a cooling tab (66) which projects from the printed circuit board (32) and is formed by the busbar (28) and which is dimensioned such that it fits through the recess (72).

5. Electric heating device according to claim 4, **characterized in that** the busbar (28) between the cooling tab (66) and the contact surface (62) forms a first support (70) and next to the contact surface (64) at the side opposite the cooling tab (66), a second support (68) provided near the contact surface.

6. Electric heating device according to any one of the preceding claims, **characterized in that** that a plurality of recesses (72) are provided and that the busbar (28) forms a plurality of contact surfaces (64) which are each exposed in one of the recesses (72) and that neighboring contact surfaces (64) are interconnected via a connection web (74) forming a second support (76).

7. Electric heating device according to any one of the preceding claims, **characterized in that** the busbar (28) comprises a locking leg (86, 88) which comprises a locking leg base (90) extending in parallel with and at a distance from the second surface (52), and a locking leg lug (92) which extends substantially at a right angle with the locking leg base (9) and passes through a locking opening (94) of the printed circuit board (32) and which comprises a locking cam (96) locking against the first surface (42).

8. Electric heating device according to claim 7, **characterized in that** the locking leg (86) comprises a contact leg (98) which is bent towards the printed circuit board (32) and abuts next to the locking opening (94) on the printed circuit board (32).

9. Electric heating device according to claim 7 or 8, **characterized in that** the locking leg (86) branches off from a busbar base section (60) provided at a distance from the printed circuit board (32), which forms the contact surface (64) via the second support (68) provided near the contact surface.

10. Electric heating device according to claim 9, **characterized in that in that** the busbar base (60) by shaping a sheet-metal strip forming the busbar (28) is supported via shaped contact points (84) at a distance from the printed circuit board (32) on said circuit board.

11. Electric heating device according to claim 9 or 10, **characterized in that** the printed circuit board (32) comprises a plurality of receiving slits (36) provided side by side for contact tabs (20), which electrically connect the heating block (2) to the printed circuit board (32) and which are covered at least in part by the busbar base (60).

12. Electric heating device according to any one of the preceding claims, **characterized in that** at least two busbars (28, 30) are provided that form connection tabs (58, 102) which are arranged next to one another and aligned at a right angle with the printed circuit board (32), and that a contact tongue piece (106, 108) is fastened to at least one of the connection lugs (68, 102).

13. Electric heating device according to any one of the preceding claims, **characterized in that** the housing comprises a housing base (12) in which the heating block (2) and the contact tabs (20) are accommodated and which is connected to contact tab receptacles (18) which accommodate the contact tabs (20) and over which the contact tabs (20) slightly project and on which the printed circuit board (32) is positioned.

## Revendications

1. Dispositif de chauffage électrique, notamment dispositif de chauffage électrique pour un véhicule automobile, comprenant un bloc chauffant (2) comportant au moins un élément (4) émettant de la chaleur, qui est relié de façon à transmettre la chaleur avec un élément de production de chaleur (6) comportant au moins un élément PTC (à coefficient de température positif) (8), le dispositif comprenant également un boitier (12) destiné à accueillir le bloc chauffant (2) et un dispositif de commande (24) prévu de manière à former une unité de construction avec le bloc chauffant (2), le dispositif de commande comportant une plaque de circuit imprimé (32), qui est équipée de composants (34) et est en contact avec au moins une barrette de courant ou de connexion (28, 30),
**caractérisé**
**en ce que** la barrette de connexion (28, 30) forme des premiers appuis (48, 70) et des deuxièmes appuis (50, 68, 76, 80, 82, 100), les premiers appuis (48, 70) coopérant avec une première surface (42) de la plaque de circuit imprimé (32), et les deuxièmes appuis (50, 68, 76, 80, 82, 100) avec une deuxième surface (52) de la plaque de circuit imprimé (32), et
**en ce que** la plaque de circuit imprimé (32) présente au moins un évidement (72),
**en ce que** la barrette de connexion (28) forme une surface de contact (64) librement dégagée dans l'évidement (72) et sur laquelle est fixée un transistor de puissance (34), et
**en ce que** la barrette de connexion présente les premiers et deuxièmes appuis (70; 68, 76, 80) au voisinage de ladite surface de contact (64).

2. Dispositif de chauffage électrique selon la revendication 1, **caractérisé en ce que** les premiers et deuxièmes appuis (48; 50) de la barrette de connexion (30) forment une griffe (46) qui enserre la plaque de circuit imprimé (32).

3. Dispositif de chauffage électrique selon la revendication 2, **caractérisé en ce que** la griffe (46) comprend deux premiers appuis (48) prévus à distance l'un de l'autre et un deuxième appui (50) prévu entre les deux précédents.

4. Dispositif de chauffage électrique selon l'une des revendications précédentes, **caractérisé par** une ailette de refroidissement (66), qui fait saillie de la plaque de circuit imprimé (32) et est formée par la barrette de connexion (28), et qui est conçue pour pouvoir passer à travers l'évidement (72).

5. Dispositif de chauffage électrique selon la revendication 4, **caractérisé en ce que** la barrette de connexion (28) forme entre l'ailette de refroidissement (66) et la surface de contact (64), un premier appui (70), et au voisinage de la surface de contact (64), sur le côté opposé à celui où se trouve l'ailette de refroidissement (66), un deuxième appui (68) proche de la surface de contact.

6. Dispositif de chauffage électrique selon l'une des revendications précédentes, **caractérisé en ce que** sont prévus plusieurs évidements (72), et **en ce que** la barrette de connexion (28) forme plusieurs surfaces de contact (64), qui sont chacune librement dégagées dans l'un des évidements (72), et **en ce que** des surfaces de contact (64) voisines sont reliées mutuellement par l'intermédiaire d'une nervure de liaison (74) formant un deuxième appui (76).

7. Dispositif de chauffage électrique selon l'une des revendications précédentes, **caractérisé en ce que** la barrette de connexion (28) présente une branche d'encliquetage (86, 88), qui comprend une base de branche d'encliquetage (90) s'étendant parallèlement et à distance de la deuxième surface (52), et une languette de branche d'encliquetage (92) s'étendant sensiblement de manière perpendiculaire à la base de branche d'encliquetage (90), traversant une ouverture de verrouillage (94) de la plaque de circuit imprimé (32), et comportant un cran d'encliquetage (96) verrouillant contre la première surface (42).

8. Dispositif de chauffage électrique selon la revendication 7, **caractérisé en ce que** la branche d'encliquetage (86) présente une branche d'appui (98), qui est repliée en direction de la plaque de circuit imprimé (32) et s'appuie contre la plaque de circuit imprimé (32) au voisinage de l'ouverture de verrouillage (94).

9. Dispositif de chauffage électrique selon la revendication 7 ou la revendication 8, **caractérisé en ce que** la branche d'encliquetage (86) est issue d'un tronçon de base de barrette de connexion (60) prévu à distance de la plaque de circuit imprimé (32), et qui forme la surface de contact (64) par l'intermédiaire du deuxième appui (68) proche de la surface de contact.

10. Dispositif de chauffage électrique selon la revendication 9, **caractérisé en ce que** la base de barrette de connexion (60) s'appuie sur la plaque de circuit imprimé (32) à distance de celle-ci, par des points d'appui (84) réalisés par déformation d'une bande de tôle formant la barrette de connexion (28).

11. Dispositif de chauffage électrique selon la revendication 9 ou la revendication 10, **caractérisé en ce que** la plaque de circuit imprimé (32) présente plusieurs fentes d'accueil (36) prévues côte à côte et destinées à des pattes de contact (20), qui raccordent électriquement le bloc chauffant (2) à la plaque de circuit imprimé (32) et sont recouvertes, au moins partiellement, par la base de barrette de connexion (60).

12. Dispositif de chauffage électrique selon l'une des revendications précédentes, **caractérisé en ce que** sont prévues au moins deux barrettes de connexion (28, 30), qui forment des pattes de raccordement (58, 102) agencées au voisinage les unes des autres et orientées perpendiculairement à la plaque de circuit imprimé (32), et **en ce que** sur l'une au moins des pattes de raccordement (58, 102) est fixée une pièce de languette de contact (106, 108).

13. Dispositif de chauffage électrique selon l'une des revendications précédentes, **caractérisé en ce que** le boitier comprend une base de boitier (12) dans laquelle sont logés le bloc chauffant (2) et les pattes de contact (20), et qui est reliée à des logements de pattes de contact (18) accueillant les pattes de contact (20) et dont dépassent légèrement les pattes de contact (20), et sur lesquels repose la plaque de circuit imprimé (32).
